# EUROPÄISCHE PATENTSCHRIFT

(11) **EP 1 772 900 B1**
(45) Veröffentlichungstag und Bekanntmachung des Hinweises auf die Patenterteilung: **25.04.2012**
(21) Anmeldenummer: 06020799.0
(22) Anmeldetag: 04.10.2006
(51) Int. Cl.: H01L 21/98, H01L 21/60, H01L 25/07, H01L 23/492

(54) **Herstellungsverfahren einer Anordnung mit Leistungshalbleiterbauelementen, welches einen Schritt Drucksintern beinhaltet**
Fabrication method of a device with power semiconductor components including a pressure sintering step
Procédé de fabrication d'un dispositif avec des composants semi-conducteurs de puissance incluant une étape de frittage sous pression

(30) Priorität: 05.10.2005 DE 102005047566
(43) Veröffentlichungstag der Anmeldung: 11.04.2007
(73) Patentinhaber: Semikron Elektronik GmbH & Co. KG Patentabteilung, 90431 Nürnberg (DE)
(72) Erfinder: Heidenreich, Dirk, 91054 Erlangen (DE); Stockmeier, Thomas, Dr., 91054 Erlangen (DE)

(56) Entgegenhaltungen:
- EP-A- 0 491 389
- EP-A- 1 599 078
- DE-A1- 10 303 103
- DE-A1- 19 612 838
- KLAKA S ET AL: "REDUCTION OF THERMOMECHANICAL STRESS BY APPLYING A LOW TEMPERATURE JOINING TECHNIQUE" PROCEEDINGS OF THE INTERNATIONAL SYMPOSIUM ON POWER SEMICONDUCTOR DEVICES (ISPSD). DAVOS, CH, MAY 31 - JUNE 2, 1994; [PROCEEDINGS OF THE INTERNATIONAL SYMPOSIUM ON POWER SEMICONDUCTOR DEVICES (ISPSD)], NEW YORK, IEEE, US, Bd. SYMP. 6, 31. Mai 1994 (1994-05-31), Seiten 259-264, XP000505826 ISBN: 978-0-7803-1495-5

## Beschreibung

Die Erfindung beschreibt ein Verfahren zur Herstellung einer Anordnung mit mindestens zwei Leistungshalbleiterbauelementen und mit einem Gehäuse, beispielhaft ausgestaltet als Leistungshalbleitermodul. Einen Ausgangspunkt der Erfindung bilden somit Leistungshalbleitermodule wie sie beispielhaft aus der DE 197 19 703 A1 und der EP 0 513 410 B1 bekannt sind

Derartige Leistungshalbleitermodule bestehen aus einem Gehäuse mit mindestens einem darin angeordneten elektrisch isolierenden Substrat vorzugsweise zur direkten Montage auf einem Kühlkörper. Das Substrat besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weist das Leistungshalbleitermodul Anschlusselemente für externe Last- und Hilfskontakte und in seinem Inneren angeordnete Verbindungselemente auf. Diese Verbindungselemente für schaltungsgerechte Verbindungen im Inneren des Leistungshalbleitermoduls sind meist als Drahtbondverbindungen (gemäß DE 197 19 703 A1), oder als auf das Leistungshalbleiterbauelement gelötet Stanz- Biege- Teile (gemäß EP 0 513 410 B1) ausgebildete auf.

Nachteilig an Drahtbondverbindungen speziell für Leistungshalbleiterbauelemente mit hoher Stromtragfähigkeit pro Flächeneinheit ist, dass diese eine Vielzahl von Bonddrähten und jeder Bonddraht eine Mehrzahl von Bondfüßen aufweisen muss um die notwendigen Stromtragfähigkeit der Bondverbindung zu erreichen. Weiterhin nachteilig an Bondverbindungen ist, dass die elektrische Verbindung über eine Mehrzahl von voneinander beabstandeten Bondfüßen hergestellt wird und somit der Stromeintrag auf die Kontaktfläche dies Leistungshalbleiterbauelement nicht homogen erfolgt.

Lötverbindungen eignen sich zum homogenen Stromeintrag auf die Kontaktflächen der Leistungshalbleiterbauelemente. Hierzu muss die Lötverbindung allerdings einen großen Teil der Kontaktfläche bedecken. Hierbei erweist sich die unterschiedliche thermische Ausdehnung des Leistungshalbleiterbauelements und des Verbindungselements als nachteilig. Dieser Nachteil wird gemindert durch relativ dicke Lotschichten, vorzugsweise aus hochbleihaltigem Lot, und durch den Einsatz von Trimetallverbindungselementen. Derartige Verbindungen weisen dann allerdings einen hohen elektrischen und thermischen Widerstand auf.

Ebenfalls bekannt sind druckkontaktierte Leistungshalbleitermodule, wie sie beispielhaft aus der DE 103 60 573 A1 bekannt sind. Hierbei ist zwischen einer Grundplatte und einem Druck einleitenden Element ein Leistungshalbleiterbauelement angeordnet. Derzeit sind druckkontaktierte Aufbauten, bei denen der Druck direkt auf das Leistungshalbleiterbauelement eingeleitet wird, besonders für Leistungsdioden und Leistungsthyristoren bekannt. Nachteilig an derartigen Aufbauten ist weiterhin, dass der Druck selektiv für jedes Leistungshalbleiterbauelement getrennt eingeleitet wird.

Den grundlegenden Stand der Technik für Verbindungen in Drucksintertechnik bildet die DE 34 14 065 C2. Diese offenbart ein Verfahren, das durch folgende wesentliche Verarbeitungsschritte gekennzeichnet ist:
- Aufbringen einer aus einem Metallpulver und einem Lösungsmittel bestehenden pastösen Schicht auf die zu verbindende Kontaktfläche eines einzelnen Bauelements;
- Aufbringen des Bauelements auf ein Substrat, wobei die pastöse Schicht zwischen dem Bauelement und dem Substrat angeordnet wird;
- Austreiben des Lösungsmittels aus dem Verbund aus Bauelement, pastöser Schicht und Substrat;
- Erwärmung des Verbunds auf Sintertemperatur, unter zusätzlicher Druckbeaufschlagung.

Bekannt ist weiterhin ein Verfahren gemäß der nachveröffentlichten DE 10 2004 019 567 A1, wobei dieses Verfahren den Vorteil aufweist für eine Mehrzahl von Leistungshalbleiterbauelementen die vorbereitenden Schritte der Drucksinterverbindung gleichzeitig durchführen zu können. Die eigentliche Sinterverbindung wird weiterhin selektiv für jedes Leistungshalbleiterbauelement einzeln ausgeführt. Das Verfahren weist die folgenden Schritte auf:
- Aufbringen einer aus einem Metallpulver und einem Lösungsmittel bestehenden pastösen Schicht auf eine Trägerfolie;
- Trocknen der pastösen Schicht;
- Aufbringen von mindestens einem Bauelement auf die getrocknete Schicht;
- Druckbeaufschlagung des Verbunds aus dem mindestens einen Bauelement und der Trägerfolie mit der getrockneten Schicht, wodurch die Haftkraft zwischen der Schicht und dem Bauelement größer wird als zwischen der Schicht und der Trägerfolie;
- Abheben des mindestens einen Bauelements mit daran haftender Schicht von der Trägerfolie;
- Positionierung des Bauelements mit der daran haftenden Schicht auf dem Substrat;
- Druck- und Temperaturbeaufschlagung der Anordnung des Substrats und des Bauelements zu deren Sinterverbindung.

Die EP 0 491 389 B1 offenbart ein Leistungshalbleiterbauelement mit einem Metallformkörper, der auf der Kontaktfläche der ersten Hauptfläche des Leistungshalbleiterbauelements mittels einer Drucksinterverbindung angeordnet ist. Die gesamte Anordnung mit dem Leistungshalbleiterbauelement weist zwei Anschlusselemente auf, mittels derer Strom durch das Leistungshalbleiterbauelement fließt. Diese Anschlusselemente sowie ein Gehäuse begrenzen die Anordnung. Weiterhin offenbart die DE 103 03 103 A1 ein mikroelektronisches Bauteil mit zwei Trägem und mindestens einem dazwischen angeordneten Halbleiterchip auf einem keramischen Substrat mit Leiterbahnen. Der verbleibende Zwischenraum ist mit einer Vergussmasse aufgefüllt, die bündig mit den Stirnseiten der Träger abschließt.

Der Erfindung liegt die Aufgabe zugrunde ein Herstellungsverfahren einer Anordnung mit mindestens zwei auf einem Substrat angeordneten Leistungshalbleiterbauelementen und mit einem Gehäuse vorzustellen, wobei die Stromeinleitung auf der dem Substrat abgewandten Seite der Leistungshalbleiterbauelemente vollständig homogen erfolgt.

Die Aufgabe wird erfindungsgemäß gelöst durch die Maßnahmen der Merkmale des Anspruchs 1. Bevorzugte Ausführungsformen sind in den Unteransprüchen beschrieben.

Der erfinderische Gedanke bezieht sich auf die Herstellung einer Anordnung mit mindestens zwei Leistungshalbleiterbauelementen und einem elektrisch isolierenden Gehäuse. Diese Anordnung weist nach außen führende Anschlusselemente und mindestens ein vom Gehäuse zumindest teilweise umschlossenes elektrisch isolierendes Substrat auf. Auf der ersten Hauptfläche des Substrats ist jeweils die zweite Hauptfläche der Leistungshalbleiterbauelemente angeordnet und elektrisch leitend verbunden.

Auf seiner dem Substrat abgewandten ersten Hauptfläche weist mindestens ein Leistungshalbleiterbauelement mindestens eine Kontaktfläche mit einer Metallisierungsschicht auf. Diese Metallisierungsschicht ist als Edelmetallschicht zur Drucksinterverbindung ausgebildet. Die Anordnung weist weiterhin einen Metallformkörper auf, dessen zweite Hauptfläche ebenfalls eine Edelmetallschicht aufweist. Dieser Metallformkörper ist mit einer der genannten Kontaktflächen des Leistungshalbleiterbauelements mittels einer Drucksinterverbindung verbunden.

Das erfindungsgemäße Herstellungsverfahren geht aus von einer Mehrzahl von Leistungshalbleiterbauelementen im Waferverbund mit jeweils pro Leistungshalbleiterbauelement mindestens einer Kontaktfläche mit einer Metallisierungsschicht aus einem Edelmetall auf der ersten Hauptfläche. Das Verfahren weist unter anderem folgende Schritte auf:
- Selektives Aufbringen einer aus einem Metallpulver, vorzugsweise Silber, und einem Lösungsmittel bestehenden pastösen Schicht auf die Kontaktflächen der Leistungshalbleiterbauelemente
- Trocknen der pastösen Schicht;
- Aufbringen von jeweils einem Metallformkörper mit einer Edelmetallschicht auf die jeweilige getrocknete Schicht über der Kontaktfläche;
- Druckbeaufschlagung auf eine Mehrzahl von Leistungshalbleiterbauelementen mit darauf angeordneten Metallformkörpern zu deren Sinterverbindung;
- Vereinzelung der Leistungshalbleiterbauelemente aus dem Waferverbund;
- Anordnung der Leistungshalbleiterbauelemente mit Metallformkörper auf dem Substrat,
- Schaltungsgerechte Verbindung der Leistungshalbleiterbauelemente mit darauf angeordnetem Metallformkörper mit Verbindungs- und Anschlusselementen;
- Anordnung des Gehäuses.

Die erfinderische Lösung wird an Hand der Ausführungsbeispiele der Fig. 1 bis 4 weiter erläutert.

Fig. 1 zeigt eine erfindungsgemäß hergestellte Anordnung in Ausgestaltung eines Leistungshalbleitermoduls.

Fig. 2 zeigt in dreidimensionaler Darstellung eine erste erfindungsgemäß hergestellte Anordnung eines Metallformkörpers auf einem Leistungshalbleiterbauelement.

Fig. 3 zeigt in dreidimensionaler Darstellung eine zweite erfindungsgemäß hergestellte Anordnung eines Metallformkörpers auf einem Leistungshalbleiterbauelement.

Fig. 4 zeigt Schritte des erfindungsgemäßen Herstellungsverfahrens.

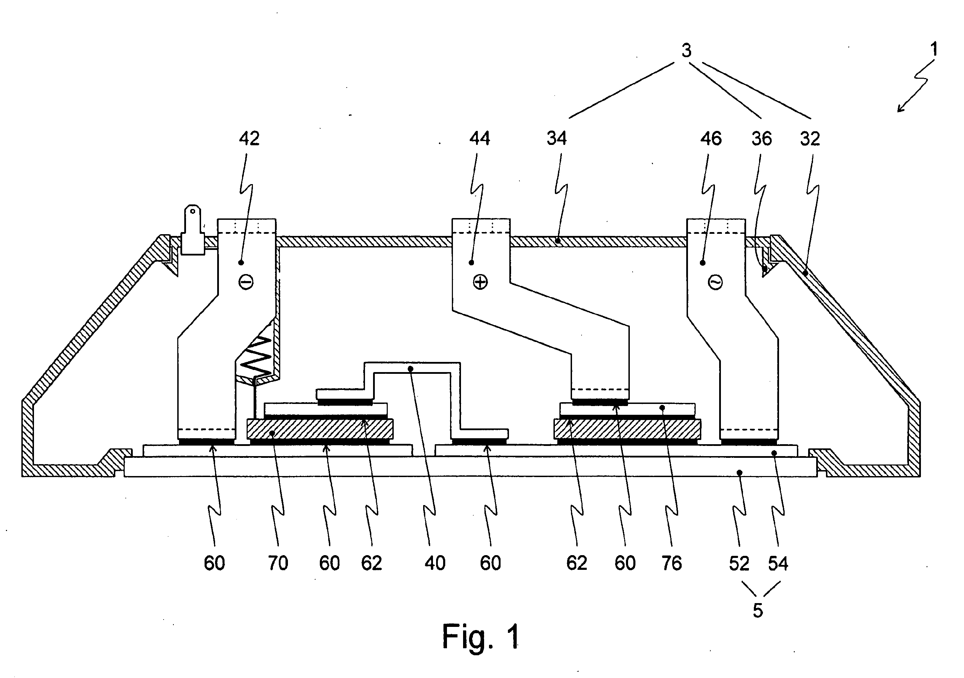

Fig. 1 zeigt eine erfindungsgemäß hergestellte Anordnung (1), hier ein Leistungshalbleitermodul, mit einem Gehäuse (3), welches einen rahmenartigen Gehäuseteil (32) sowie einen Deckel (34) mit Rastnasen (36) zur Schnapp- RastVerbindung mit dem rahmenartigen Gehäuseteil (32), aufweist. Der rahmenartige Gehäuseteil (32) umschließt ein Substrat (5). Dieses weist einen Isolierstoffkörper (52), vorzugsweise eine Isolierkeramik, wie Aluminiumoxid oder Aluminiumnitrid, und auf deren dem Inneren des Leistungshalbleitermoduls zugewandten ersten Hauptfläche eine in sich strukturierte Kupferkaschierung auf. Die einzelnen Abschnitte dieser Kupferkaschierung bilden die Leiterbahnen (54) des Leistungshalbleitermoduls.

Auf diesen Leiterbahnen (54) sind Leistungshalbleiterbauelemente (70), Anschlusselemente (42, 44, 46) für Lastanschlüsse und Verbindungselemente (40) angeordnet. All diese Komponenten sind mittels Lötverbindungen (60) mit den Leiterbahnen (54) verbunden. Die Lastanschlusselement (42, 44, 46) dienen der externen Verbindung der Leistungshalbleiterbauelemente (70), die Verbindungselemente (40) dienen der schaltungsgerechten internen Verbindung der Leistungshalbleiterbauelemente (70).

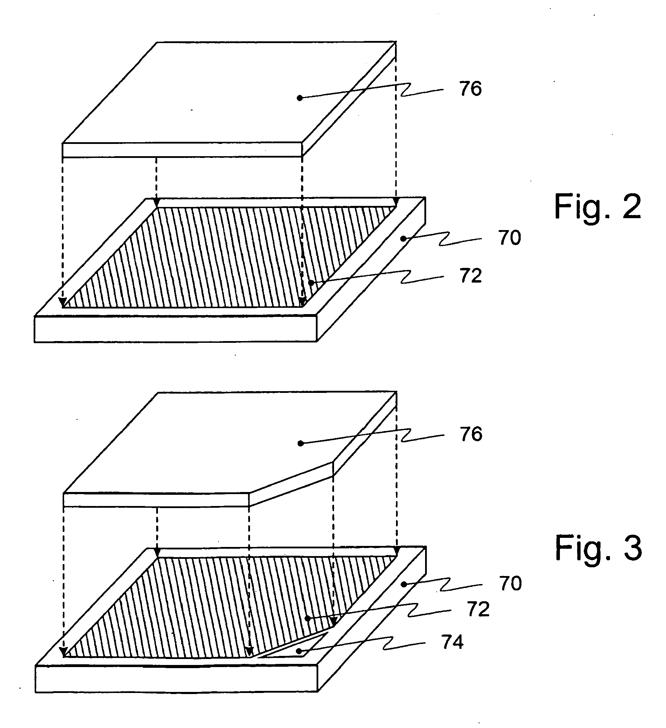

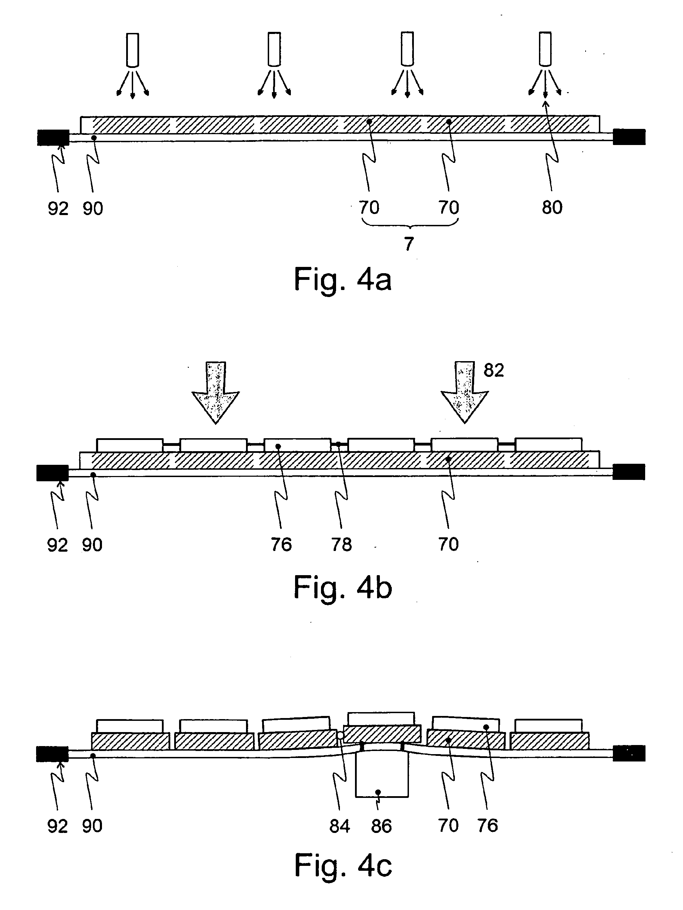

Die Leistungshalbleiterbauelemente (70), hier eine Leistungsdiode und ein Leistungsthyristor, weisen auf ihrer dem Substrat (5) abgewandten ersten Hauptfläche Kontaktflächen, vgl. Fig. 3 und 4, zur elektrischen Kontaktverbindung auf. Diese Kontaktflächen weisen eine zur Drucksinterverbindung geeignete Edelmetalloberfläche (62), vorzugsweise aus Gold, auf. Auf dieser Kontaktfläche und mit dieser mittels einer Drucksinterverbindung elektrisch leitend verbunden ist ein Metallformkörper (76) angeordnet.

Dieser Metallformkörper (76) besteht vorzugsweise aus Kupfer und ist im Bereich der Drucksinterverbindung mit einer galvanisch aufgebrachten Edelmetalloberfläche versehen. Dieser Metallformkörper (76) ist mit einem Verbindungselement (40) löttechnisch verbunden. Hierin liegt ein besonderer Vorteil von Drucksinterverbindungen, die auch bei höheren Temperaturen, beispielhaft im Bereich um 300°C noch eine dauerhaft sichere elektrische Verbindung bei gleichzeitig hoher mechanischer Stabilität ermöglichen. Somit sind auch nachträgliche ausgeführte Verbindungen wie Löt- (60), Bond- oder weitere Drucksinterverbindungen mit diesem Verbund aus Leistungshalbleiterbauelement (70) und Metallformkörper (76) möglich.

Besonders vorteilhaft ist dieser Verbund aus Leistungshalbleiterbauelement (70) und Metallformkörper (76), da bei Bond- oder nicht flächig ausgebildeten Lötverbindungen (60) mittels dieses Metallformkörpers (76) die Stromeinprägung in das Leistungshalbleiterbauelement (70) gleichmäßig über die gesamte Kontaktfläche erfolgt und somit das Leistungshalbleiterbauelement (70) homogen über seine Ausdehnung belastet wird, was einer verbesserten Leistungsfähigkeit und höherer Zuverlässigkeit dient.

Fig. 2 zeigt in dreidimensionaler Darstellung eine erste erfindungsgemäß hergestellte Anordnung eines Metallformkörpers (76) auf einem ungesteuerten Leistungshalbleiterbauelement (70) hier einer Leistungsdiode. Die Leistungsdiode (70) weist hierzu auf ihrer ersten Hauptfläche eine Kontaktfläche (72) auf. Diese Kontaktfläche (72) weist eine mehrlagige Metallisierungsstruktur auf, wobei die oberste Lage aus einem Edelmetall besteht, da dies für eine Drucksinterverbindung notwendig ist.

Auf diesem Leistungshalbleiterbauelement (70) aus Gründen der Übersichtlichkeit beabstandet dargestellt ist ein Metallformköper (76) mit den lateralen Ausdehnungen der Kontaktfläche (76) angeordnet und mit dieser mittels einer Drucksinterverbindung elektrisch leitend verbunden. Zur Ausgestaltung dieser Drucksinterverbindung vgl. Fig. 4. Der Metallformkörper (76) ist als Quader aus Kupfer oder Molybdän oder aus einer diese beiden Metalle zu mindestens 80 von 100 Volumenanteilen enthaltenden Legierung ausgebildet. Auf seiner zweiten dem Leistungshalbleiterbauelement (70) zugewandten Seite weist der Metallformkörper (76) eine Edelmetallschicht auf, die mindestens der Größe der Kontaktfläche (72) des Leistungshalbleiterbauelements (70) entspricht. Vorzugweise ist der gesamte Metallformkörper (76) mit einer galvanisch aufgebrachten Edelmetallschicht überzogen.

Der flächige, quaderförmig ausgebildete, Metallformkörper (76) weist eine Dicke von maximalen 50 von 100 seiner größten lateralen Ausdehnung auf. Der Verbund aus Leistungshalbleiterbauelement (70) und mittels Drucksinterverfahren angeordnetem Metallformkörper (76) kann in Anordnungen mit Druckkontakt-, Löt-, Klebe- oder weiteren Drucksinterverbindungen schaltungsgerecht verbunden werden.

Fig. 3 zeigt in dreidimensionaler Darstellung eine zweite erfindungsgemäß hergestellte Anordnung eines Metallformkörpers (76) auf einem Leistungshalbleiterbauelement (70) hier einem gesteuerten Leistungsschalter, beispielhaft einem IGBT (insulated gate bipolar transistor). Die erste Hauptfläche des Leistungshalbleiterbauelements (70) weist hierbei zwei Kontaktflächen (72, 74), eine großflächige (72) zur Lastverbindung und eine weitere Kontaktfläche (74) geringerer Ausdehnung zur Steuerverbindung auf. Die Kontaktfläche (74) zur Steuerverbindung wir hierbei durch den zugeordneten Metallformkörper (76) nicht abgedeckt und kann somit beispielhaft mittels Drahtbondtechnik nach dem Stand der Technik verbunden werden. Der Metallformkörper (76) ist daher mit einer Aussparung an einer Ecke ausgebildet.

Fig. 4 zeigt Schritte des erfindungsgemäßen Herstellungsverfahrens. Ausgangspunkt hierbei sind eine Mehrzahl von Leistungshalbleiterbauelementen (70) im Waferverbund auf einer in einem Rahmen (92) angeordneten Trägerfolie (90). Jedes Leistungshalbleiterbauelement (70) weist mindestens eine Kontaktfläche auf der ersten, der Trägerfolie abgewandten Hauptfläche auf. Diese Kontaktfläche weist ihrerseits eine oberste Metallisierungsschicht aus einem Edelmetall auf.

In einem ersten Schritt wird selektiv auf eine Mehrzahl Kontaktflächen der Leistungshalbleiterbauelemente eine pastöse Schicht aus einem Metallpulver und einem Lösungsmittel aufgebracht. Besonders bevorzugt ist hierbei das Aufsprühen (80) durch eine Sprühmaske oder der Siebdruck der Paste.

In einem weiteren Schritt werden die Metallformkörper (76) auf den Kontaktflächen der Leistungshalbleiterbauelemente (70) angeordnet. Es ist hierbei besonders bevorzugt, wenn die Metallformkörper (76) im Verbund, also eine Mehrzahl gleichzeitig, angeordnet werden. Hierzu können die Metallformkörper (76) beispielhaft mittels Stegen (78) miteinander verbunden sein oder die Metallformkörper (76) sind selbst auch auf einem Trägermaterial, ähnlich der Trägerfolie (90) der Leistungshalbleiterbauelemente (70) angeordnet.

Das Trocknen der pastösen Schicht erfolgt entweder vor oder nach diesem Herstellungsschritt des Aufbringens der Metallformkörper (76).

Anschließend erfolgt die gleichzeitige Druckbeaufschlagung (82) auf eine Mehrzahl von Leistungshalbleiterbauelementen (70) mit darauf angeordneten Metallformkörpern (76) zu deren jeweiliger Sinterverbindung. In weiteren Prozessschritten werden die Leistungshalbleiterbauelemente (70) mit darauf angeordneten Metallformkörpern (76), vorzugsweise mittels Sägen, vereinzelt (84) und mit bekannten Verfahren (86) von der Trägerfolie abgenommen und beispielhaft in einem Leistungshalbleitermodul angeordnet.

## Patentansprüche

1. Verfahren zur Herstellung einer Anordnung (1) mit mindestens zwei Leistungshalbleiterbauelementen (70) und einem elektrisch isolierenden Gehäuse (3), weiterhin mit mindestens einem Verbindungselement (40) zur schaltungsgerechten internen Verbindung der Leistungshalbleiterbauelemente, mit nach außen führenden Anschlusselementen (42, 44, 46), mindestens einem vom Gehäuse (3) zumindest teilweise umschlossenen elektrisch isolierenden Substrat (5), wobei mindestens zwei Leistungshalbleiterbauelemente (70) auf auf dem Substrat angeordneten Leiterbahnen angeordnet sind,
wobei das Verfahren folgende Schritte aufweist:
a) Bereitstellen einer Mehrzahl von Leistungshalbleiterbauelementen (70) im Waferverbund, wobei auf einer Seite des Waferverbundes jedes Leistungshalbleiterbauelement (70) auf einer ersten Hauptfläche mindesten eine Kontaktfläche mit einer Metallisierungsschicht (72) aufweist, die aus einem Edelmetall besteht:
b) Selektives Aufbringen (80) einer aus einem Metallpulver und einem Lösungsmittel bestehenden pastösen Schicht auf die Kontaktflächen der Leistungshalbleiterbauelemente (70);
c) Trocknen dieser pastösen Schicht;
d) Bereitstellen von Metallformkörpern (76), die jeweils mindestens auf einer zweiten Hauptfläche ebenfalls eine Edelmetallschicht aufweisen;
e) Aufbringen von jeweils einem Metallformkörper (76) mit einer Edelmetallschicht auf die jeweilige getrocknete Schicht über der Kontaktfläche, sodass die zweite Hauptfläche des Metallformkörpers der Kontaktfläche zugewandt ist;
f) Druckbeaufschlagung (82) auf eine Mehrzahl von Leistungshalbleiterbauelementen (70) mit darauf angeordneten Metallformkörpern (76) zu deren Sinterverbindung;
g) Vereinzelung (84) der Leistungshalbleiterbauelemente (70) und der hiermit verbundenen Metallformkörper (76) aus dem Waferverbund;
h) Anordnung mindestens zweier mit jeweils mindestens einem Metallformkörper (76) verbundenen Leistungshalbleiterbauelemente (70) auf den Leiterbahnen (54), wobei sich jeder Metallformkörper (76) auf der dem isolierenden Substrat (5) abgewandten Seite des jeweiligen Leistungshalbleiterbauelements befindet;
i) shaltungsgerechte Verbindung der jeweils mit mindestens einem Metallformkörper (76) verbundenen Leistungshalbleiterbauelemente (70) und der Anschlusselementen;
j) Anordnung des Gehäuses.

2. Verfahren nach Anspruch 1
wobei der Teilschritt b) mittels eines Siebdruckverfahrens ausgeführt wird.

3. Verfahren nach Anspruch 1
wobei die einzelnen Metallformkörper (76) beim Teilschritt e) im Verbund angeordnet sind.

4. Verfahren nach Anspruch 1
wobei der Teilschritt g) mittels eines Sägeverfahrens ausgeführt wird.

## Claims

1. A method for the manufacture of an arrangement (1) with at least two power semiconductor components (70) and an electrically insulating housing (3), with furthermore at least one connecting element (40) for purposes of internal connection of the power semiconductor components in accordance with circuit requirements, with terminal elements (42, 44, 46) leading to the external environment, and at least one electrically insulating substrate (5) at least partially enclosed by the housing (3), wherein
at least two power semiconductor components (70) are arranged on conducting tracks arranged on the substrate, wherein
the method has the following steps:
a) Preparation of a multiplicity of power semiconductor components (70) in a wafer composite, wherein on one side of the wafer composite each power semiconductor component (70) on a first main surface has at least one contact surface with a metallised layer (72), which consists of a noble metal;
b) Selective application (80) of a paste layer, consisting of a metal powder and a solvent, onto the contact surfaces of the power semiconductor components (70);
c) Drying of this paste layer;
d) Preparation of shaped metal bodies (76), which in each case similarly have a noble metal layer on at least a second main surface;
e) Application in each case of a shaped metal body (76) with a noble metal layer onto the respective dried layer via the contact surface, such that the second main surface of the shaped metal body is facing towards the contact surface;
f) Application of pressure (82) onto a multiplicity of power semiconductor components (70), with thereon arranged shaped metal bodies (76), in order to create their sintered joints;
g) Separation (84) of the power semiconductor components (70) and the herewith connected shaped metal bodies (76) from the wafer composite;
h) Arrangement of at least two power semiconductor components (70), connected in each case with at least one shaped metal body (76), onto the conducting tracks (54), wherein each shaped metal body (76) is located on the side of the respective power semiconductor component facing away from the insulating substrate (5);
i) Connection in accordance with circuit requirements of the power semiconductor components (70), connected in each case with at least one shaped metal body (76), and the terminal elements;
j) Arrangement of the housing.

2. The method in accordance with Claim 1, wherein
step b) is executed by means of a screen printing method.

3. The method in accordance with Claim 1, wherein
in step e) the individual shaped metal bodies (76) are arranged in the composite.

4. The method in accordance with Claim 1, wherein
step g) is executed by means of a sawing method.

## Revendications

1. Procédé pour fabriquer un agencement (1) comprenant au moins deux composants à semi-conducteurs de puissance (70) et un boîtier (3) électriquement isolant, également avec au moins un élément de liaison (40) pour la liaison interne conforme au circuit des composants à semi-conducteurs de puissance, des éléments de branchement (42, 44, 46) dirigés vers l'extérieur, au moins un substrat (5) électro-isolant, entouré au moins partiellement par le boîtier (3), au moins deux composants à semi-conducteurs de puissance (70) étant disposés sur des pistes conductrices disposées sur le substrat,
le procédé présentant les étapes suivantes :
a) mise à disposition d'une pluralité de composants à semi-conducteurs de puissance (70) dans le composite de tranche, chaque composant à semi-conducteurs de puissance (70) présentant sur un côté du composite de tranche sur une première surface principale au moins une surface de contact avec une couche de métallisation (72), qui est à base d'un métal noble ;
b) application (80) sélective d'une couche pâteuse, à base d'une poudre de métal et d'un solvant, sur les surfaces de contact des composants à semi-conducteurs de puissance (70) ;
c) séchage de cette couche pâteuse ;
d) mise à disposition de corps moulés en métal (76), qui présentent également une couche de métal noble à chaque fois au moins sur une seconde surface principale ;
e) application de respectivement un corps moulé en métal (76) avec une couche de métal noble sur la couche séchée respective au-dessus de la surface de contact, de sorte que la seconde surface principale du corps moulé en métal est tournée vers la surface de contact ;
f) application de pression (82) sur une pluralité de composants à semi-conducteurs de puissance (70) avec des corps moulés en métal (76) disposés dessus pour leur liaison de frittage ;
g) séparation (84) des composants à semi-conducteurs de puissance (70) et des corps moulés en métal (76) reliés à ces composants du composite de tranche ;
h) agencement d'au moins deux composants à semi-conducteurs de puissance (70) reliés à respectivement au moins un corps moulé en métal (76) sur les pistes conductrices (54), chaque corps moulé en métal (76) se trouvant sur le côté opposé au substrat (5) isolant, du composant à semi-conducteurs de puissance respectif ;
i) liaison conforme au circuit des composants à semi-conducteurs de puissance (70) reliés respectivement à au moins un corps moulé en métal (76) et des éléments de raccordement ;
j) agencement du boîtier.

2. Procédé selon la revendication 1,
l'étape partielle b) étant réalisée au moyen d'un procédé de sérigraphie.

3. Procédé selon la revendication 1,
les différents corps moulés en métal (76) étant disposés dans le composite lors de l'étape partielle e).

4. Procédé selon la revendication 1,
l'étape partielle g) étant réalisée au moyen d'un procédé de sciage.
